(19) **Europäisches Patentamt / European Patent Office / Office européen des brevets**

(11) **EP 4 568 107 A1**

(12) # EUROPEAN PATENT APPLICATION

(43) Date of publication:
**11.06.2025 Bulletin 2025/24**

(21) Application number: **24162027.7**

(22) Date of filing: **07.03.2024**

(51) International Patent Classification (IPC):
*H03F 3/00* $^{(2006.01)}$    *H03F 3/45* $^{(2006.01)}$

(52) Cooperative Patent Classification (CPC):
**H03F 3/005; H03F 3/45183; H03F 3/45659;**
H03F 2200/375; H03F 2200/48; H03F 2203/45008;
H03F 2203/45044; H03F 2203/45082;
H03F 2203/45088; H03F 2203/45134;
H03F 2203/45171; H03F 2203/45176;
H03F 2203/45191; H03F 2203/45194;
H03F 2203/45202;      (Cont.)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **06.12.2023 IN 202341083189**

(71) Applicant: **NXP B.V.**
**5656 AG Eindhoven (NL)**

(72) Inventors:
• **Panpalia, Jagdish G.**
  **5656AG Eindhoven (NL)**
• **Karadi, Ravichandra**
  **5656AG Eindhoven (NL)**
• **Bergveld, Hendrik Johannes**
  **5656AG Eindhoven (NL)**

(74) Representative: **Miles, John Richard**
**NXP SEMICONDUCTORS**
**Intellectual Property Group**
**Abbey House**
**25 Clarendon Road**
**Redhill, Surrey RH1 1QZ (GB)**

(54) **DIFFERENTIAL AMPLIFIER**

(57) A differential amplifier includes a differential input, and a differential output. The differential amplifier further includes at least one capacitor switchably coupled to at least one bias voltage source during a first phase. The differential amplifier further includes a pair of input transistors having an input-transistor-first-terminal coupled to a first supply node, an input-transistor-second-terminal coupled to a respective one output of the differential output, and an input-transistor-control-terminal switchably coupled to (i) a second supply node during a second phase and (ii) a respective one input of the differential input during a third phase. The differential amplifier includes a pair of load transistors having a load-transistor-first-terminal coupled to a respective one output of the differential output, a load-transistor-second-terminal coupled to the second supply node, and a load-transistor-control-terminal. The at least one capacitor is switchably coupled between the load-transistor-first-terminal and the load-transistor-control-terminal during the second phase and the third phase.

300
FIG. 4

(52) Cooperative Patent Classification (CPC): (Cont.)
H03F 2203/45206; H03F 2203/45208;
H03F 2203/45221; H03F 2203/45396;
H03F 2203/45418; H03F 2203/45434;
H03F 2203/45444; H03F 2203/45536;
H03F 2203/45544; H03F 2203/45551;
H03F 2203/45616; H03F 2203/45628;
H03F 2203/45631; H03F 2203/45634;
H03F 2203/45644; H03F 2203/45681;
H03F 2203/45691; H03F 2203/45702;
H03F 2203/45726

**Description**

FIELD

This disclosure relates to a differential amplifier.

BACKGROUND

Differential gain stages with diode-connected loads are used frequently in multistage amplifier/comparator circuits. They have the advantage of being fully differential amplifiers with a gain which may be for example 15 to 20 dB per stage and can be implemented without requiring explicit common-mode feedback circuitry (CMFB). However, at low supply voltages, the lowered voltage headroom results in the transistors operating in the linear region of operation, which reduces the gain. An alternative is to use the differential amplifier with a resistive load. However, the gain of this topology is limited by the dc voltage drop across the resistors. This requires more cascaded stages to build an amplifier or comparator with a certain desired gain, increasing the area and current consumption.

A typical application of such a differential-pair gain stage is in the Zero-Current-Detector (ZCD) block used in a DC-DC converter circuit. Accurately detecting the zero-current-crossing condition in the inductor during the Discontinuous-Conduction Mode (DCM) prevents diode conduction losses in the low-side power switch, thereby improving the overall efficiency of the converter.

SUMMARY

Aspects of the disclosure are defined in the accompanying claims. In a first aspect, there is provided a differential amplifier comprising: a pair of inputs; a pair of outputs; at least one capacitor configured to be switchably coupled to at least one bias voltage source during a first phase; a pair of input transistors, each input transistor comprising: an input-transistor-first-terminal coupled to a first supply voltage node; an input-transistor-second-terminal coupled to a respective one of the pair of outputs; and an input-transistor-control-terminal configured to be switchably coupled to a second supply voltage node during a second phase and to be switchably coupled to a respective one of the pair of inputs during a third phase and; a pair of load transistors, each load transistor comprising: a load-transistor-first-terminal coupled to a respective one of the pair of outputs; a load-transistor-second-terminal coupled to the second supply voltage node; a load-transistor-control-terminal; and wherein the at least one capacitor is further configured to be: switchably coupled between the load-transistor-first-terminal and the load-transistor-control-terminal of each of the pair of load transistors during the second phase and the third phase.

In some embodiments, the at least one capacitor comprises a capacitor having a capacitor-first-terminal and capacitor-second-terminal, and the at least one bias voltage source comprises a bias voltage source having a bias-voltage-source-first-terminal and a bias-voltage-source-second-terminal; wherein the capacitor-first-terminal is switchably coupled to the bias-voltage-source-first-terminal during the first phase and switchably coupled to the load-transistor-control-terminal of each of the pair of load transistors during the second phase and the third phase, and the capacitor-second-terminal is switchably coupled to the bias-voltage-source-second-terminal during the first phase and switchably coupled to the load-transistor-first -terminal of each of the pair of load transistors via a respective resistor during the second phase and the third phase.

In some embodiments, the at least one capacitor comprises a first capacitor and a second capacitor, each of the first capacitor and the second capacitor having a capacitor-first-terminal and capacitor-second-terminal, and the at least one bias voltage source comprises a first bias voltage source and second bias voltage source, each of the first bias voltage source and the second bias voltage source having a bias-voltage-source-first-terminal and a bias-voltage-source-second-terminal; and wherein each capacitor-first-terminal is switchably coupled to a respective bias-voltage-source-first-terminal during the first phase and switchably coupled to a respective load-transistor-control -terminal of each of the pair of load transistors during the second phase and the third phase, and each capacitor-second-terminal is switchably coupled to a respective bias-voltage-source-second-terminal during the first phase and switchably coupled to a respective load-transistor-first -terminal of each of the pair of load transistors during the second phase and the third phase.

In some embodiments, the differential amplifier further comprises: a pair of output capacitors (C11, C12), each output capacitor coupled between a respective one of the pair of pair of outputs and the input-transistor-second-terminal of a respective one of the pair of input transistors. In some embodiments, each output of the pair of outputs is switchably coupled to the second supply voltage node during the second phase.

In some embodiments, the differential amplifier further comprises: a pair of input capacitors (C31, C32), each input capacitor having a first input capacitor terminal coupled to an input-transistor-control-terminal of a respective input transistor a second input capacitor terminal configured to be switchably coupled to a second supply voltage node during a second phase and to be switchably coupled to a respective one of the pair of inputs during a third phase. In some embodiments, each output of the pair of outputs is switchably coupled to the input-transistor-control-terminal of a respective input transistor during the second phase.

In some embodiments, the differential amplifier further comprises: a pair of latch transistors, each latch transistor comprising; a latch-transistor-control-terminal coupled to the load-transistor-control terminal of a respective one of the pair of load transistors; a latch-transistor-first-terminal coupled to the load-transistor-first-terminal of a respective other of the pair of load transistors; and a latch-transistor-second-terminal coupled to the second supply voltage node (Vss).

In some embodiments, the differential amplifier further comprises: a current source arranged between the first supply voltage node and the input-transistor-first-terminal of each input transistor. In some embodiments, the pair of input transistors are PMOS transistors and the pair of load transistors are NMOS transistors. In some embodiments, the first voltage supply node is configured to provide a supply voltage and the second voltage supply node is configured as a ground. In some embodiments, the pair of input transistors are NMOS transistors and the pair of load transistors are PMOS transistors. In some embodiments, the first voltage supply node is configured as a ground and the second voltage supply node is configured to provide a supply voltage.

In some embodiments, the first phase is a pre-charge phase, the second phase is an auto-zero phase and the third phase is a compare phase. Some embodiments of the differential amplifier may be configured as a comparator. The comparator may be configured as a zero-current detector.

In a second aspect, there is provided a method of operating a differential amplifier comprising a pair of inputs, a pair of outputs, a pair of input transistors and a pair of load transistors wherein each input transistor comprises an input-transistor-first-terminal coupled to a first supply voltage node, an input-transistor-second-terminal coupled to a respective one of the pair of outputs and an input-transistor-control-terminal, and each load transistor comprises a load-transistor-first-terminal coupled to a respective one of the pair of outputs, a load-transistor-second-terminal coupled to a second supply voltage node; and a load-transistor-control-terminal, the method comprising: precharging at least one capacitor to a bias voltage during a first phase; coupling the at least one capacitor between the load-transistor-first-terminal and the load-transistor-control-terminal of the pair of load transistors during a second phase and a third phase; coupling each input-transistor-control-terminal to the second supply voltage node during the second phase; and coupling each input-transistor-control-terminal to a respective one of the pair of inputs during the third phase. In some embodiments, the method further comprises coupling the pair of outputs to the second supply voltage node during the second phase. In some embodiments, the method further comprises coupling each of the pair of outputs to a respective input-transistor-control-terminal of the pair of input transistors during the second phase.

BRIEF DESCRIPTION OF THE DRAWINGS

In the figures and description like reference numerals refer to like features. Embodiments are now described in detail, by way of example only, illustrated by the accompanying drawings in which:

Figure 1 shows a typical example differential amplifier.

Figure 2 illustrates a typical example differential amplifier.

Figure 3 shows a typical example differential amplifier.

Figure 4 shows a differential amplifier according to an embodiment.

Figure 5 illustrates a differential amplifier according to an embodiment.

Figure 6 shows a differential amplifier according to an embodiment.

Figure 7 illustrates a timing diagram showing the timing phases of operation of the differential amplifiers of figure 4, figure 5, and figure 6.

Figure 8 illustrates an example bias circuit implementation for the differential amplifiers of figure 4, figure 5, and figure 6.

Figure 9 shows the simulation result at room temperature and a low supply voltage of 0.8V, for the differential amplifiers of figure 1, figure 4 and figure 5.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments.

DETAILED DESCRIPTION OF EMBODIMENTS

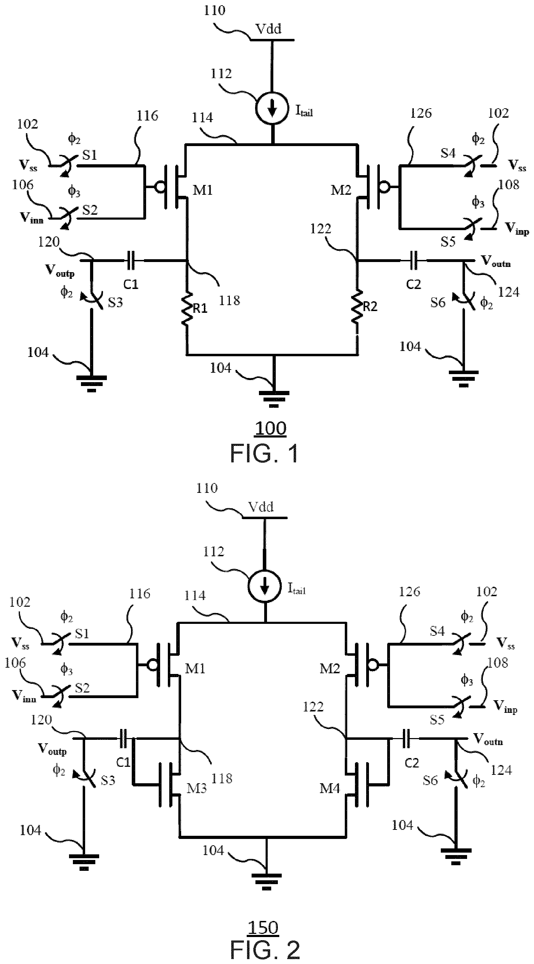

Figure 1 shows an example differential amplifier 100. The differential amplifier 100 has a pair of inputs 106 ($V_{inn}$), 108 ($V_{inp}$) also referred to as a differential input and a pair of outputs 120 ($V_{outp}$), 124 ($V_{outn}$) also referred to as a differential output. The differential amplifier 100 has a pair of PMOS input transistors M1, M2.

The first input transistor M1 of the pair of transistors has a first transistor gate (input-transistor-control-terminal) 116 connected to a second supply voltage node 102 ($V_{ss}$) typically a ground via a first switch S1 controlled by a switch control signal $\phi2$. The switch control signal $\phi2$ may also be referred to as an auto-zero phase switch signal. The first transistor gate 116 is connected to a first input 106 ($V_{inn}$) of the pair of inputs via a second switch S2 controlled by a switch control signal $\phi3$. The switch control signal $\phi3$ may also be referred to as a comparison- or amplification-phase switch signal.

A source (input-transistor-first-terminal) of the first input transistor M1 is connected to circuit node 114. The circuit node 114 is connected to a first terminal of current source 112. A second terminal of current source 112 is connected to a first supply voltage node ($V_{dd}$) 110.

A drain (input-transistor-second-terminal) of the first transistor M1 is connected to circuit node 118. The circuit node 118 is connected to a first terminal of first resistor R1. A second terminal of first resistor R1 is connected to ground 104. The circuit node 118 is connected to a first terminal of a first output capacitor C1. A second terminal of the first output capacitor C1 is connected to the first output 120 ($V_{outp}$) of the pair of outputs. The first output 120 ($V_{outp}$) is connected via a third switch S3 to ground 104 controlled by the auto-zero-phase switch signal ($\phi2$).

The second input transistor M2 of the pair of transistors has a second transistor gate (input-transistor-control-terminal) 126 connected to a second supply voltage node 102 ($V_{ss}$) typically a ground via a fourth switch S4 controlled by the switch control signal $\phi2$. The second transistor gate 126 is connected to a second input 108 ($V_{inp}$) of the pair of inputs via a fifth switch S5 controlled by the switch control signal $\phi3$.

A source (input-transistor-first-terminal) of the second input transistor M2 is connected to circuit node 114. A drain (input-transistor-second-terminal) of the second transistor M2 is connected to circuit node 122. The circuit node 122 is connected to a first terminal of a second resistor R2. A second terminal of the second resistor R2 is connected to ground 104. The circuit node 122 is connected to a first terminal of a second output capacitor C2. A second terminal of the second output capacitor C2 is connected to the second output 124 ($V_{outn}$) of the pair of outputs. The second output 124 ($V_{outp}$) is connected via a sixth switch S6 to ground 104 controlled by the auto-zero-phase switch signal ($\phi2$). The auto-zero-phase switch signal ($\phi2$) and the comparison-phase switch signal ($\phi3$) are derived from different phases of a clock signal and repeat each clock cycle.

In operation, the state of the switches during the auto-zero phase and amplification phase for amplifier 100 is shown in table 1.

*Table 1*

| Switch | Auto-zero phase ($\phi2$ active) | Amplification/Comparison phase ($\phi3$ active) |
|---|---|---|
| S1 | closed | open |
| S2 | open | closed |
| S3 | closed | open |
| S4 | closed | open |
| S5 | open | closed |
| S6 | closed | open |

The first and second resistors R1, R2 have the same value denoted R0. The gain of the differential amplifier 100 is given by $g_{m1,m2}$ * R0. The value of R0 becomes a limiting factor to get higher gain, since simply increasing its resistance will eventually reduce the drain-source voltage $V_{ds}$ of the PMOS input pair M1, M2, thereby driving the differential amplifier 100 into the linear region of operation. The first and second capacitors C1, C2 form offset-storing capacitors at the outputs 120,124 of the amplifier 100, on which the offset voltage of the PMOS input pair M1, M2 is stored at the stage outputs 120, 124 in the auto-zeroing phase $\phi2$. During the auto-zeroing phase $\phi2$, the inputs of the PMOS input pair M1, M2 are both grounded to $V_{ss}$, while the differential output $V_{out} = V_{outp} - V_{outn}$, which corresponds to the amplified differential-stage offset voltage in this situation, is sampled on capacitors C1, C2. In the amplification phase the differential input voltage $V_{inp}$-$V_{inn}$ is amplified to differential output voltage $V_{outp}$-$V_{outn}$, the capacitors C1, C2 are switched in series with the differential output voltage, thereby compensating for the amplified input offset voltage of the PMOS input pair M1, M2 at its output.

Figure 2 shows an example differential amplifier 150. The differential amplifier 150 replaces first resistor R1 and second resistor R2 with a pair of NMOS load transistors M3, M4. The first load transistor M3 of the pair of load transistors has a gate (load-transistor-control-terminal) and drain (load-transistor-first-terminal) connected to circuit node 118. A source (load-transistor-second-terminal) of the first load transistor M3 is connected to ground 104.

The second load transistor M4 of the pair of load transistors has a gate (load-transistor-control-terminal) and drain (load-transistor-first-terminal) connected to circuit node 122. A source (load-transistor-second-terminal) of the second load transistor M4 is connected to ground 104. In other respects the differential amplifier 150 is the same as differential amplifier 100.

The operation of the switches S1 to S6 is as described for amplifier 100. Replacing the resistive load R1, R2 by a diode-connected load transistors M3, M4 may increase the gain of the amplifier 150 compared to amplifier 100. Increasing the gain of a single stage helps achieving the required overall amplifier/comparator gain with fewer stages which may reduce power consumption and the die area required for implementation. However, the diode voltage across the diode-connected NMOS load transistors M3, M4 creates a similar voltage headroom problem for the PMOS input stage as the problem described in relation to amplifier 100, especially when the supply voltage is low. However, another problem arises, with the input common-mode voltage at 0V during the auto-zeroing phase and during the amplification stage, and assuming that the $V_{gs}$ value of the diode-connected NMOS transistors M3, M4 is 400mV to maintain saturation margins, while the minimum $V_{ds}$ values are assumed to be 200mV. In that case, the available voltage for the diode-connected loads is only 200mV. Therefore, the input common-mode voltage cannot be lower than ~200mV, to ensure the input transistors M1, M2 are biased in the saturation region. Consequently, additional circuitry is required to raise the input common-mode voltage to a voltage sufficiently above the $V_{ss}$ level. The auto-zero phase operation is the same as previously described for amplifier 100.

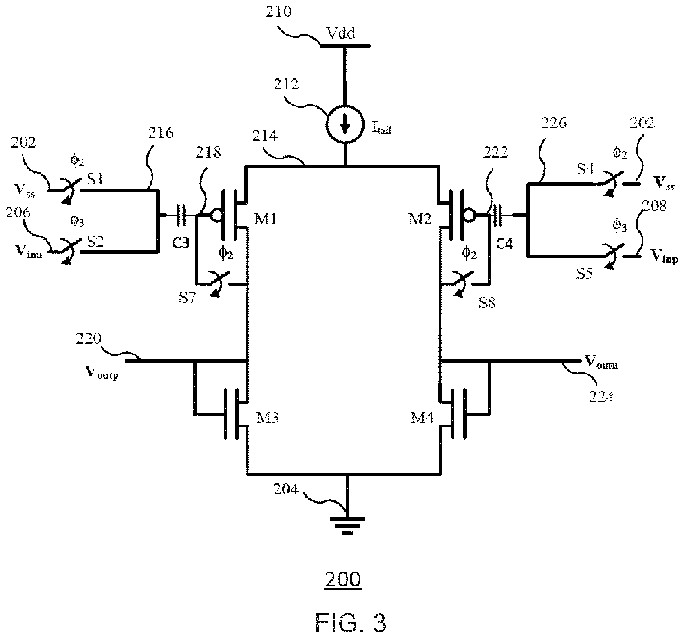

Figure 3 shows an example differential amplifier 200. The differential amplifier 200 has a pair of inputs 206 ($V_{inn}$), 208 ($V_{inp}$) also referred to as a differential input and a pair of outputs 220 ($V_{outp}$), 224 ($V_{outn}$). The differential amplifier 200 has a pair of PMOS input transistors M1, M2 and a pair of NMOS load transistors M3, M4.

The first input transistor M1 of the pair of transistors has a first transistor gate (input-transistor-control-terminal) 218 connected to a first terminal of a first input capacitor C3. A second terminal 216 of the first input capacitor C3 is connected to second supply voltage node 202 ($V_{ss}$) typically a ground via a first switch S1 controlled by the auto-zero-phase switch signal ($\phi$2). The second terminal of the first input capacitor C3 216 is connected to a first input 206 ($V_{inn}$) of the pair of inputs via a second switch S2 controlled by a comparison-phase switch signal ($\phi$3). The first transistor gate 218 is connected to the first output 220 ($V_{outp}$) of the pair of outputs via a third switch S7.

A source (input-transistor-first-terminal) of the first input transistor M1 is connected to circuit node 214. The circuit node 214 is connected to a first terminal of current source 212. A second terminal of current source 212 is connected to a voltage supply ($V_{dd}$) 210.

A drain (input-transistor-second-terminal) of the first transistor M1 is connected to the first output 220 ($V_{outp}$). A first load transistor M3 of the pair of NMOS load transistors has a gate (load-transistor-control-terminal) and drain (load-transistor-first-terminal) connected to the first output 220. A source (load-transistor-second-terminal) of the first load transistor M3 is connected to ground 204.

The second input transistor M2 of the pair of transistors has a first transistor gate (input-transistor-control-terminal) 222 connected to a first terminal of a second input capacitor C4. A second terminal 226 of the second input capacitor C4 is connected to second supply voltage node 102 ($V_{ss}$) typically a ground via a fourth switch S4 controlled by the auto-zero phase switch signal ($\phi$2). The second terminal 226 of the second input capacitor C4 is connected to a second input 208 ($V_{inp}$) of the pair of inputs via a fifth switch S5 controlled by a comparison-phase switch signal ($\phi$3). The second transistor gate 222 is connected to the second output 220 ($V_{outp}$) of the pair of outputs via a sixth switch S8.

A source (input-transistor-first-terminal) of the second input transistor M2 is connected to circuit node 214.

A drain (input-transistor-second-terminal) of the second input transistor M2 is connected to the second output 224 ($V_{outn}$). A second load transistor M4 of the pair of NMOS load transistors has a gate (load-transistor-control-terminal) and drain (load-transistor-first-terminal) connected to the second output 224. A source (load-transistor-second-terminal) of the second load transistor M4 is connected to ground 204.

In operation, the state of the switches during the auto-zero phase and amplification phase for amplifier 200 is shown in table 2.

*Table 2*

| Switch | Auto-zero phase ($\phi$2 active) | Amplification/Comparison phase ($\phi$3 active) |
|---|---|---|
| S1 | closed | open |

(continued)

| Switch | Auto-zero phase (φ2 active) | Amplification/Comparison phase (φ3 active) |
|---|---|---|
| S2 | open | closed |
| S7 | closed | open |
| S4 | closed | open |
| S5 | open | closed |
| S8 | closed | open |

The amplifier 200 differs from amplifier 150 by the implementation of the offset cancellation circuit. In other respects, the operation is the same. Input capacitors C3, C4 form the offset-storage capacitors instead of output capacitors C1, C2 used for amplifier 150. During the auto-zeroing phase φ2, the input transistors $M_1$ and M2 are connected in diode formation. The minimum supply voltage, $V_{dd,min}$, required during the auto-zeroing phase is now given by

$$V_{dd,min} = V_{gsM3,M4} + V_{gsM1,M2} + V_{ds\text{-}tail}$$

Since both the NMOS and PMOS transistors are now diode-connected. Assuming that for both the PMOS and NMOS transistors that the $V_{gs}$ value required to maintain saturation is 400mV, while the $V_{ds}$ value for the tail current source is ~200mV, we need minimum supply voltage of ~1V ( 400mV + 400mV + 200mV).

For the amplifier 150 with the output offset-storage scheme, the minimum common-mode voltage $V_{cm}$ is derived from:

$$V_{cm} + V_{gsM1,M2} = V_{dsM1,M2+} V_{gsM3,M4}$$

For values of $V_{gs}$ = 400mV, $V_{ds}$-$_{tail}$ - 200mV, the minimum common-mode voltage is 200 mV, hence for a 0.8 volt supply, a common-mode voltage of 0 volt is not achievable since the diode-connected load transistors M3, M4 would only have 200 mV available. Consequently this will require an additional pre-amplifier stage to raise the input common-mode voltage. For the amplifier 200 with input offset-storage scheme, the input common-mode voltage can be 0V, due to level shifting provided by the input offset storage capacitors. However, the minimum supply voltage $V_{dd,min}$ of 1 volt is higher than amplifier 150.

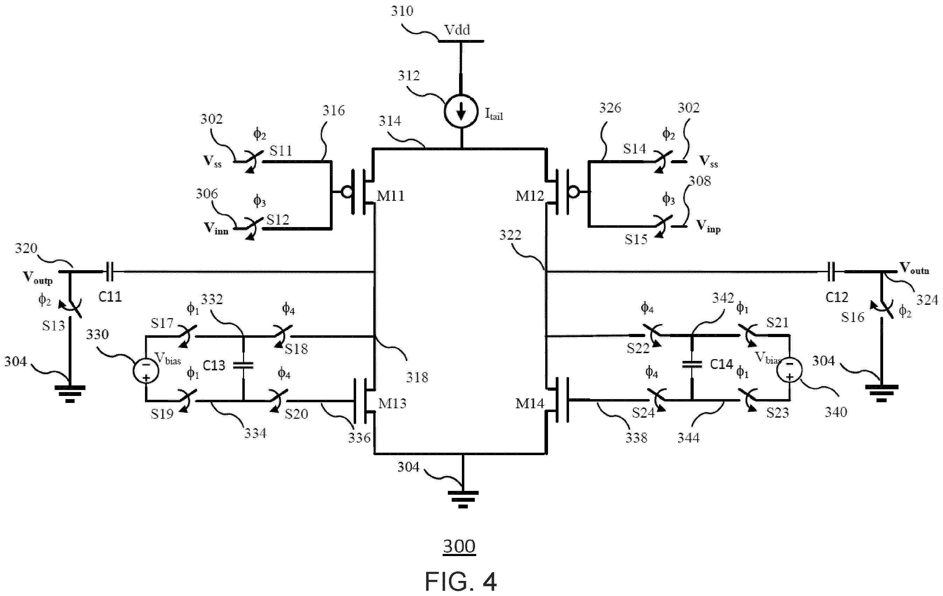

Figure 4 shows a differential amplifier 300 according to an embodiment with output offset cancellation. The differential amplifier 300 has a pair of inputs 306 (Vinn), 308 (Vinp) also referred to as a differential input and a pair of outputs 320 (Voutp), 324 (Voutn). The differential amplifier 300 has a pair of PMOS input transistors M11, M12 and a pair of NMOS load transistors M13, M14.

The first input transistor M11 of the pair of transistors has a first transistor gate (input-transistor-control-terminal) 316 connected to a second supply voltage node 302 ($V_{ss}$) typically a ground via a first switch S11 controlled by a switch control signal φ2. The switch control signal φ2 may also be referred to as an auto-zero-phase switch signal. The first transistor gate 316 is connected to a first input 306 ($V_{inn}$) of the pair of inputs via a second switch S12 controlled by a switch control signal φ3. The switch control signal φ3 may also be referred to as a comparison-phase switch signal.

A source (input-transistor-first-terminal) of the first input transistor M11 is connected to circuit node 314. The circuit node 314 is connected to a first terminal of current source 312. A second terminal of current source 312 is connected to a first voltage supply node ($V_{dd}$) 310.

A drain (input-transistor-second-terminal) of the first transistor M11 is connected to circuit node 318. The circuit node 318 is connected to a first terminal of a first output capacitor C11. A second terminal of the first output capacitor C11 is connected to the first output 320 ($V_{outp}$) of the pair of outputs. The first output 320 ($V_{outp}$) is connected via a third switch S13 to ground 304 controlled by the auto-zero-phase switch signal (φ2).

The circuit node 318 is connected to a drain of the first load transistor M13 and is connected via a switch S18 to a first terminal 332 of capacitor C13. The first terminal 332 of capacitor C13 is connected via switch S17 to the negative terminal of the voltage bias 330. The positive terminal of the voltage bias 330 is connected via switch S19 to the second terminal of capacitor C13. The second terminal 334 of capacitor C13 is connected via switch S20 to the gate 336 of the first load transistor M13. Switches S18, S20 are controlled by switch signal φ4 which is equivalent to φ2 || φ3, i.e. is the duration of the auto-zero phase and the comparison phase. Switches S17, S19 are controlled by switch signal φ1 which may also be referred to as the pre-charge phase. The source of the first load capacitor M13 is connected to ground 304.

The second input transistor M12 of the pair of transistors has a second transistor gate (input-transistor-control-terminal) 326 connected to a second supply voltage node 302 ($V_{ss}$) typically a ground via a fourth switch S14 controlled by the switch control signal $\phi$2. The second transistor gate 326 is connected to a second input 308 ($V_{inp}$) of the pair of inputs via a fifth switch S15 controlled by the switch control signal $\phi$3.

A source (input-transistor-first-terminal) of the second input transistor M12 is connected to circuit node 314. A drain (input-transistor-second-terminal) of the second transistor M12 is connected to circuit node 322. The circuit node 322 is connected to a first terminal of a second output capacitor C12. A second terminal of the second output capacitor C12 is connected to the second output 324 ($V_{outn}$) of the pair of outputs. The second output 324 ($V_{outp}$) is connected via a sixth switch S16 to ground 304 controlled by the auto-zero-phase switch signal ($\phi$2).

The circuit node 322 is connected to a drain of the second load transistor M14 and is connected via a switch S22 to a first terminal 342 of capacitor C14. The first terminal 342 of capacitor C14 is connected via switch S21 to the negative terminal of the voltage bias 340. The positive terminal of the voltage bias 340 is connected via switch S23 to the second terminal of capacitor C14. The second terminal 344 of capacitor C14 is connected via switch S24 to the gate 338 of the second load transistor M14. Switches S22, S24 are controlled by switch signal $\phi$4. Switches S21, S23 are controlled by switch signal $\phi$1 which may also be referred to as the pre-charge phase. The source of the second load capacitor M14 is connected to ground 304.

In operation, the state of the switches during the pre-charge phase, auto-zero phase and amplification phase for amplifier 300 is shown in table 3. The switches may be implemented for example by an MOS transistor with the gate controlled by the relevant switch signal or a CMOS transmission gate including an NMOS and PMOS transistor controlled by the relevant switch signal and its complement (inverse).

*Table 3*

| Switch | Pre-charge phase ($\phi$1 active) | Auto-zero phase ($\phi$2 active, $\phi$4 active) | Amplification/Comparison phase ($\phi$3 active, $\phi$4 active) |
|---|---|---|---|
| S11 | open | closed | open |
| S12 | open | open | closed |
| S13 | open | closed | open |
| S14 | open | closed | open |
| S15 | open | open | closed |
| S16 | open | closed | open |
| S17 | closed | open | open |
| S18 | open | closed | closed |
| S19 | closed | open | open |
| S20 | open | closed | closed |
| S21 | closed | open | open |
| S22 | open | closed | closed |
| S23 | closed | open | open |
| S24 | open | closed | closed |

The amplifier 300 has a pair of capacitors C13, C14 that are connected via switches S17, S19, S21, S23 to the respective voltage bias source 330, 340 and are pre-charged during a pre-charge phase to the bias voltage $V_{bias}$. During the subsequent operation phases i.e. the auto-zero phase and amplification phase, the capacitors C13, C14 are connected via switches S18, S20, S21, S23 between the gate and drain of the respective NMOS diode-connected load M13, M14 of the PMOS-input-pair differential amplifier stage. The output common-mode voltage of the amplifier gain stage 300 is now $V_{g,nmos}$-$V_{c13,c14}$ instead of $V_{g,nmos}$ in the case of amplifiers 150, 200. Hence, the voltage headroom available for the diode-connected NMOS load pair M13, M14 increases by a voltage $V_{c13,c14}$. In other words, the supply voltage can be lowered approximately by $V_{c13,c14}$ compared to the amplifiers 150, 200 so may use a lower power supply of for example 0.6 volts. In addition, compared to amplifier 150, with a supply voltage of 0.8V, the input common-mode voltage can become 0V since the required common-mode voltage is also lowered by $V_{c13,c14}$. Note that the small-signal impedance of the diode-connected load NMOS transistors M13, M14 does not change, and is still given by $1/g_{m, nmos}$ as for amplifiers 150, 200.

The amplifier 300 has the advantage of using a diode-connected load in a differential amplifier stage similar to amplifiers 150, 200, which can provide more gain compared to the differential amplifier 100. The gain of the amplifier 300 is given by $g_{m11,m12}/g_{m13,m14}$, which is same as the gain of the amplifiers 150, 200.

The sequence of events to control the timed switches of the amplifier 300 is divided in 3 sections (phases), namely a first phase which may be referred to as the pre-charging phase ($\phi$1), a second phase referred to as the auto-zeroing phase ($\phi$2) and a third phase referred to as the final amplification/comparison phase ($\phi$3). During the first phase $\phi$1, the pre-charging capacitors C13, C14 are charged to a $V_{bias}$ voltage before connecting them between the gate and drain terminals of M13, M14. During the second and third phases $\phi$2 and $\phi$3, the capacitors C13, C14 are connected between the gate and drain of the respective load transistors M13, M14. The minimum supply voltage is given by,

$$V_{dd,min} = V_{ds(tail)} + V_{ds,pmos} + V_{gs,nmos} - V_{bias}.$$

For amplifier 300, $V_{dd,min}$ for the output offset storage scheme is reduced by $V_{bias}$ compared to amplifiers 100, 150. For example, $V_{ddmin}$ = 0.2V+0.2V+0.4V-0.2V = 0.6V with $V_{bias}$ = 0.2V. At this supply voltage of 0.6V, a common-mode voltage of 0V is possible. Furthermore, for a supply voltage of 0.8 volts, he common-mode input voltage can be Vss, since the minimum tail node voltage is the same as for the 0.6V supply voltage and is given by $V_{ds,pmos} + V_{gs,nmos} - V_{bias}$=0.4V. Hence, the input PMOS pair M13, M14 can be biased in saturation with the gates connected to Vss.

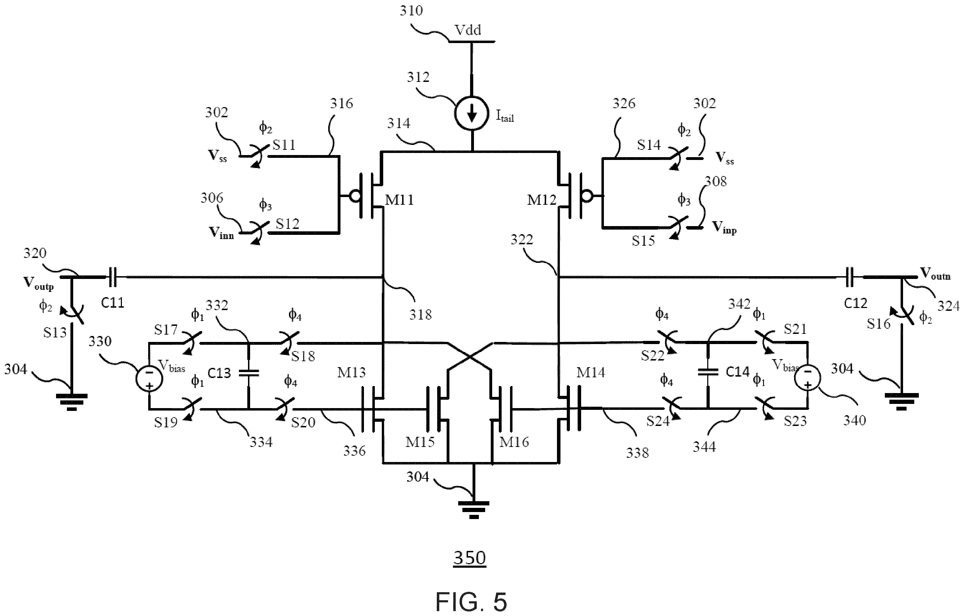

Figure 5 shows a differential amplifier 350 according to an embodiment. The differential amplifier 350 is the same as differential amplifier 300 with the addition of NMOS latch transistors M15, M16. The first latch transistor M15 has a source (latch-transistor-second terminal) connected to ground 304, a drain (latch-transistor-first terminal ) connected to circuit node 322 and a gate (latch-transistor-control terminal ) connected to the first load transistor gate 336. The second latch transistor M16 has a source connected to ground 304, a drain connected to circuit node 318 and a gate connected to the second load transistor gate 338.

The operation of amplifier 350 is the same as described for amplifier 300. Using a latch in addition to the diode-connected load transistors which may increase the gain of amplifier 350 compared to amplifier 300. The gain of amplifier 350 is approximately equal to $gm_{m11,m12}/(gm_{m13,m14}-gm_{m15,m16})$.

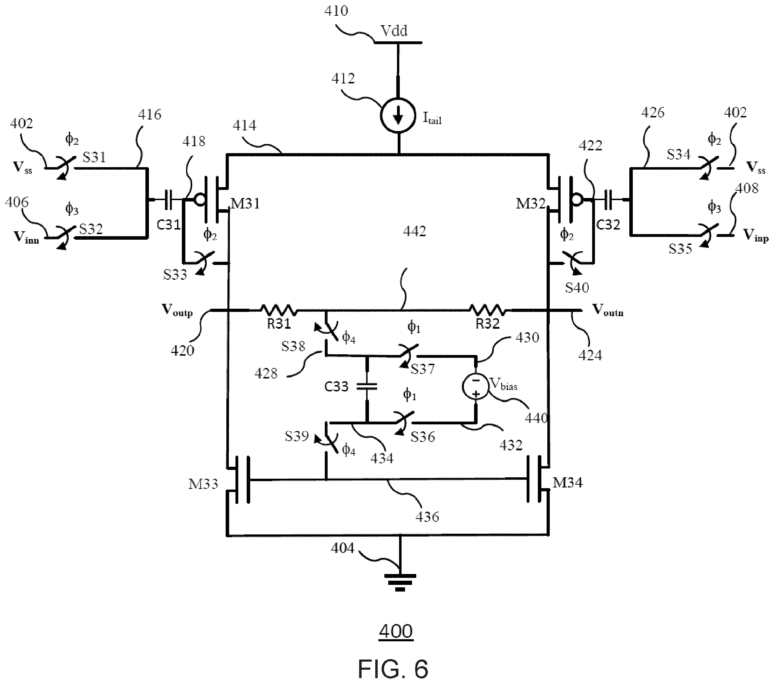

Figure 6 shows a differential amplifier 400 according to an embodiment. The differential amplifier 400 has a pair of inputs 406 ($V_{inn}$), 408 ($V_{inp}$) also referred to as a differential input and a pair of outputs 420 ($V_{outp}$), 424 ($V_{outn}$). The differential amplifier 400 has a pair of PMOS input transistors M31, M32 and a pair of NMOS load transistors M33, M34.

The first input transistor M31 of the pair of transistors has a first transistor gate (input-transistor-control-terminal) 418 connected to a first terminal of a first input capacitor C31. A second terminal of the first input capacitor C31 is connected to node 416. The node 416 is connected to a reference voltage node 402 ($V_{ss}$) typically a ground via a first switch S31 controlled by a switch control signal $\phi$2. The switch control signal $\phi$2 may also be referred to as an auto-zero-phase switch signal. The node 416 is connected to a first input 406 ($V_{inn}$) of the pair of inputs via a second switch S32 controlled by a switch control signal $\phi$3.

A source (input-transistor-first-terminal) of the first input transistor M31 is connected to circuit node 414. The circuit node 414 is connected to a first terminal of current source 412. A second terminal of current source 412 is connected to a first voltage supply node ($V_{dd}$) 410.

A drain (input-transistor-second-terminal) of the first transistor M31 is connected to the first output 420 ($V_{outp}$). The first output 420 ($V_{outp}$) is connected to the first transistor gate 418 via a third switch S33 controlled by a switch control signal $\phi$2.

The first output 420 ($V_{outp}$) is connected to a drain of the first load transistor M33 and is connected to circuit node 442 via a resistor R31. The circuit node 442 is connected via a switch S38 to a first terminal 428 of capacitor C33. The circuit node 422 is connected to a drain of the second load transistor M34 and is connected via a resistor R32 to circuit node 442. The first terminal 428 of capacitor C33 is connected via switch S37 to the negative terminal 430 of the voltage bias 440. The positive terminal 432 of the voltage bias 440 is connected via switch S36 to the second terminal 434 of capacitor C33. The second terminal 434 of capacitor C33 is connected via switch S39 to circuit node 436. Circuit node 436 is connected to the gate of the first load transistor M33 and the gate of the second load transistor M34. Switches S38, S39 are controlled by switch signal $\phi$4 which is equivalent to $\phi$2 $\|$ $\phi$3, i.e. is the duration of the auto-zero phase $\phi$2 and the comparison phase $\phi$3. Switches S37, S36 are controlled by switch signal $\phi$1 which may also be referred to as the pre-charge phase. The sources of the first load transistor M33 and second load transistor M34 are connected to ground 404.

The second input transistor M32 of the pair of transistors has a second transistor gate (input-transistor-control-terminal) 422 connected to a first terminal of a second input capacitor C32. A second terminal of the second input capacitor C32 is connected to node 426. The node 416 is connected to connected to a second voltage supply node 402 ($V_{ss}$) typically a ground via a fourth switch S34 controlled by the switch control signal $\phi$2. The node 426 is connected to a second input 408 ($V_{inp}$) of the pair of inputs via a fifth switch S35 controlled by the switch control signal $\phi$3.

A source (input-transistor-first-terminal) of the second input transistor M32 is connected to circuit node 414. A drain (input-transistor-second-terminal) of the second transistor M12 the second output 424 ($V_{outn}$) of the pair of outputs. The second output 424 ($V_{outn}$) of the pair of outputs is connected via sixth switch S40, controlled by a switch control signal $\phi2$, to the second transistor gate 422.

In operation, the state of the switches during the pre-charge phase, auto-zero phase and amplification phase for amplifier 400 are shown in table 4.

*Table 4*

| Switch | Pre-charge phase ($\phi1$ active) | Auto-zero phase ($\phi2$ active, $\phi4$ active) | Amplification/Comparison phase ($\phi3$ active, $\phi4$ active) |
|---|---|---|---|
| S31 | open | closed | open |
| S32 | open | open | closed |
| S33 | open | closed | open |
| S34 | open | closed | open |
| S35 | open | open | closed |
| S36 | closed | open | open |
| S37 | closed | open | open |
| S38 | open | closed | closed |
| S39 | open | closed | closed |
| S40 | open | closed | open |

The amplifier 400 uses an input offset storage scheme similar to amplifier 200. In other respects, the operation of amplifier 400 is the similar as described for amplifiers 300, 350 but uses only one biasing capacitor C33 and one voltage bias 440. The biasing capacitor C33 and voltage bias 440 may allow the amplifier 400 to operate at a lower supply voltage similarly to amplifier 300, 350.

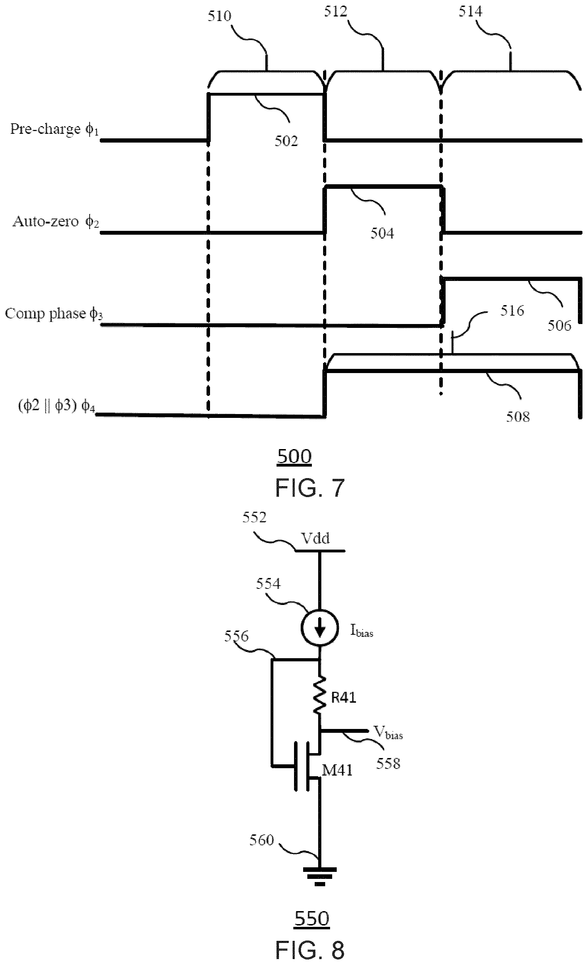

Figure 7 illustrates a timing diagram 500 showing the timing phases of operation of the differential amplifiers 300, 350, 400. Pre-charge waveform 502 ($\phi1$) has an active phase 510. Auto-zero waveform 504 ($\phi2$) has an active phase 512. Comparison phase waveform 506 ($\phi3$) has an active phase 514 and waveform 508 ($\phi4$) has an active phase 516 ($\phi2 \parallel \phi3$), i.e. the duration of phases $\phi2$ and $\phi3$. The active phases correspond to the phases in which the switches controlled by the corresponding signals are closed.

Figure 8 shows an example bias voltage reference 550 which may for example be used to implement voltage biases 330, 340, 440. NMOS transistor M41 has a source connected to ground 560, and a drain connected to the voltage bias output 558. The voltage bias output 558 is connected to a first terminal of resistor R41 and a second terminal of resistor R41 is connected to the gate 556 of the NMOS transistor M41. The gate of 552 of the NMOS transistor M41 is connected to a first terminal of current source 554. A second terminal of current source 554 connected to voltage supply 552. The minimum supply voltage for which the amplifiers 300, 350, 400 still operate is limited by the Vbias generation block 550. For amplifiers using output offset cancellation such as amplifiers 300, 350, the minimum common-mode offset voltage is also determined by the bias voltage provided by Vbias generation block 550. The bias voltage reference 550 may work for a supply voltage as low as ~700mV without compromising the voltage headroom of the current source Ibias.

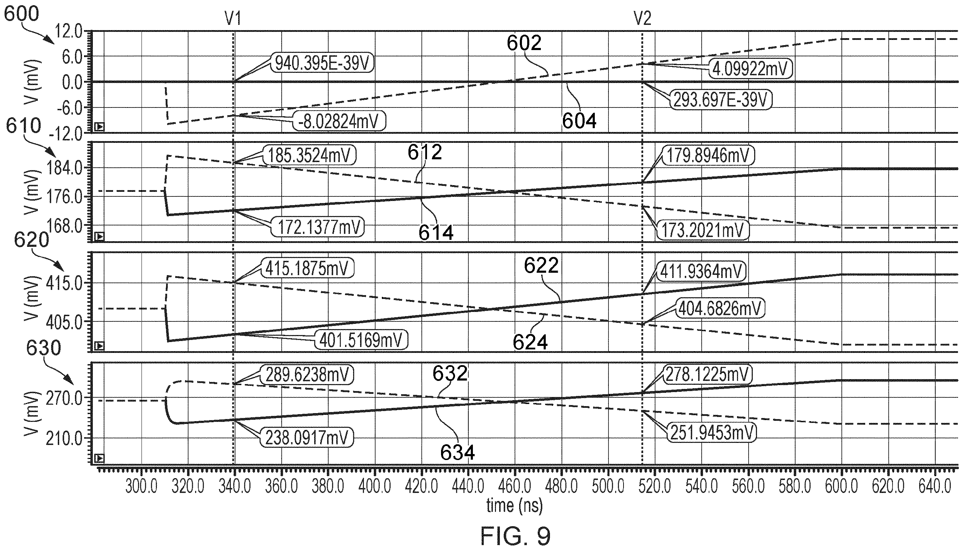

Figure 9 shows example simulation results at room temperature and a low supply voltage $V_{dd}$ of 0.8V, for the differential amplifiers 100, 300, 350. Graphs 600, 610, 620, 630 show time in nanoseconds on the x-axis and voltage varying in millivolts on the y-axis. Graph 600 shows the input voltage applied to each of the two inputs for the differential amplifiers 100, 300, 350. One of the inputs 106, 306 ($V_{inn}$) is held at 0 V shown be line 604, while the other input 108, 308 ($V_{inp}$) is ramped from -10mV to +10mV shown by line 602. Graph 610 shows the response of differential amplifier 100. The bias voltage generated for example by bias voltage circuit 550 is 300 mV. Line 612 shows the response of one of the outputs, for example output 124 which ramps down as $V_{inp}$ ramps up, and line 614 shows the response of the other output, for example output 120 which ramps up as $V_{inp}$ ramps up. Graph 620 shows the response of differential amplifier 300. Line 622 shows the response of one of the outputs, for example output 320 and line 624 shows the response of the other output, for example output 324. Graph 630 shows the response of differential amplifier 350. Line 632 shows the response of one of the outputs, for example output 324. Line 634 shows the response of the other output, for example output 320.

The input voltages are typically present at the inputs of an amplifier stage when used as an input stage for a zero-current-crossing comparator, which compares the Vss voltage to the voltage at an "LX" node in a typical DC-DC buck converter, where the LX voltage starts from a negative voltage and approaches 0 V when the current in the inductor approaches 0 A. From the waveforms it is evident that the amplifier 300 has wider differential output voltage levels and hence more gain of the amplification stage of approximately 5dB. In addition, the amplifier 300 has sufficient voltage headroom for each input transistor M11, M12 to keep it biased in saturation when compared to amplifier 100, which has an approximate gain of 4dB for the same tail current $I_{tail}$. With the latched load stage of differential amplifier 350 including latch transistors M15, M16, the gain is further significantly improved to approximately 16dB. The output offset cancellation scheme is the same for differential amplifiers 100, 300, 350.

Embodiments of the differential amplifier described herein have a PMOS-based input pair of transistors and diode-connected load formed from NMOS transistors. In other examples, a differential amplifier may use an NMOS-based input pair of transistors and diode-connected load formed from PMOS transistors, for example when a voltage close to the supply voltage needs to be amplified. The term transistor-control-terminal refers to a MOS transistor gate. The term first-transistor-terminal may refer to one of a source or drain of an MOS transistor. The term second-transistor-terminal may refer to the other of a source or drain of an MOS transistor.

Embodiments of the differential amplifier allow biasing an amplifier stage with diode-connected load stage and auto-zeroing for offset cancellation which may allow operation at lower supply voltages and a lower common-mode input voltage. Operating at reduced supply voltages reduces the quiescent current, and may avoid the use of an additional voltage domain to supply the amplifier stage. In some embodiments multiple amplifier stages 300, 350, 400 may be used in cascade for a high-gain comparator. Such a high-gain comparator can be used, for example, as a Zero-Current Detector (ZCD) in a DC-DC converter operating in Discontinuous Conduction Mode (DCM). Embodiments connect a pre-charged capacitor between the gate and drain terminals of a diode-connected load stage during additional pre-charge phase of a clock used for offset cancellation. This allows the amplifier-stage output common-mode voltage to be lower relative to the gate bias voltage of the diode-connected load. The voltage headroom of the input differential pair increases, allowing a lower supply voltage of the amplifier stage, or a lower common-mode input voltage. An additional pre-charge phase of a clock used for offset cancellation may be used to control the pre-charging of the capacitor.

Embodiments of the differential amplifier may be used in multiple products which require generation of a high-gain low-power amplifier operated from a low-voltage power supply and/or a low input common-mode voltage of 0V. Embodiments may be included in a zero-current comparator in a low-output-voltage DC-DC buck converter, where a comparator with input common-mode voltage of 0V is needed with low offset, low quiescent power and low supply voltage. Embodiments allow the common-mode voltage to be well controlled. The offset cancellation improves the accuracy of the detection. At the same time, it is advantageous from a quiescent-power-consumption point of view to operate such a ZCD circuit from the lowest available supply voltage, i.e. the output voltage of the DC-DC buck converter of e.g. 0.8V in the case of FINFET technology. When used as a ZCD comparator, both inputs are near the Vss level when detecting a zero crossing in the inductor current, since one input is connected to the Vss of the power stage, while the other input is connected to the LX node, i.e. the node in between the high-side and the low-side switch in a DC-DC converter, where the LX node voltage is equal to Vss of the power stage when the inductor current is zero. Embodiments of the differential amplifier has both a low offset and low supply voltage and may be included in such a zero-current comparator.

A differential amplifier includes a differential input, and a differential output. The differential amplifier further includes at least one capacitor switchably coupled to at least one bias voltage source during a first phase. The differential amplifier further includes a pair of input transistors having an input-transistor-first-terminal coupled to a first supply node, an input-transistor-second-terminal coupled to a respective one output of the differential output, and an input-transistor-control-terminal switchably coupled to (i) a second supply node during a second phase and (ii) a respective one input of the differential input during a third phase. The differential amplifier includes a pair of load transistors having a load-transistor-first-terminal coupled to a respective one output of the differential output, a load-transistor-second-terminal coupled to the second supply node, and a load-transistor-control-terminal. The at least one capacitor is switchably coupled between the load-transistor-first-terminal and the load-transistor-control-terminal during the second phase and the third phase.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub combination.

The applicant hereby gives notice that new claims may be formulated to such features and/or combinations of such features during the prosecution of the present application or of any further application derived therefrom.

For the sake of completeness, it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

**Claims**

1. A differential amplifier (300, 350, 400) comprising:

   a pair of inputs (306, 308; 406, 408);
   a pair of outputs (320, 324; 420, 424) ;
   at least one capacitor (C13, C14, C33) configured to be switchably coupled to at least one bias voltage source (330, 340, 440) during a first phase ($\phi$1);
   a pair of input transistors (M11,M12; M31,M32), each input transistor comprising:

   an input-transistor-first-terminal coupled to a first supply voltage node (310, 410);
   an input-transistor-second-terminal coupled to a respective one of the pair of outputs (320, 324; 420, 424); and
   an input-transistor-control-terminal configured to be switchably coupled to a second supply voltage node (302, 402) during a second phase ($\phi$2) and to be switchably coupled to a respective one of the pair of inputs (306, 308; 406, 408) during a third phase ($\phi$3) and;

   a pair of load transistors (M13,M14;M33,M34), each load transistor comprising:

   a load-transistor-first-terminal coupled to a respective one of the pair of outputs (320, 324; 420, 424);
   a load-transistor-second-terminal coupled to the second supply voltage node (302, 402);
   a load-transistor-control-terminal; and wherein

   the at least one capacitor (C13, C14, C33) is further configured to be :
   switchably coupled between the load-transistor-first-terminal and the load-transistor-control-terminal of each of the pair of load transistors during the second phase and the third phase.

2. The differential amplifier of claim 1, wherein

   the at least one capacitor comprises a capacitor (C33) having a capacitor-first-terminal (434) and capacitor-second-terminal (428), and the at least one bias voltage source comprises a bias voltage source (440) having a bias-voltage-source-first-terminal (432, Vbias+) and a bias-voltage-source-second-terminal (430, Vbias-) ;
   wherein the capacitor-first-terminal (434) is switchably coupled to the bias-voltage-source-first-terminal (432, Vbias+) during the first phase and switchably coupled to the load-transistor-control-terminal of each of the pair of load transistors during the second phase and the third phase, and the capacitor-second-terminal (428) is switchably coupled to the bias-voltage-source-second-terminal (430, Vbias-) during the first phase and switchably coupled to the load-transistor-first -terminal of each of the pair of load transistors (M33, M34) via a respective resistor (R31, R32) during the second phase and the third phase.

3. The differential amplifier of claim 1, wherein

   the at least one capacitor comprises a first capacitor (C13) and a second capacitor (C14), each of the first capacitor (C13) and the second capacitor (C14) having a capacitor-first-terminal (334, 344) and capacitor-second-terminal (332, 342) , and the at least one bias voltage source comprises a first bias voltage source (330) and second bias voltage source (340), each of the first bias voltage source (330) and the second bias voltage source (340) having a bias-voltage-source-first-terminal (Vbias+) and a bias-voltage-source-second-terminal (Vbias-); and
   wherein each capacitor-first-terminal (334, 344) is switchably coupled to a respective bias-voltage-source-first-terminal (Vbias+) during the first phase and switchably coupled to a respective load-transistor-control -terminal of each of the pair of load transistors M13, M14 during the second phase and the third phase, and each capacitor-second-terminal is switchably coupled to a respective bias-voltage-source-second-terminal during the first phase and switchably coupled to a respective load-transistor-first - terminal of each of the pair of load transistors during the second phase and the third phase.

4. The differential amplifier of any preceding claim further comprising: a pair of output capacitors (C11, C12), each output capacitor coupled between a respective one of the pair of pair of outputs and the input-transistor-second-terminal of a respective one of the pair of input transistors.

5. The differential amplifier of any preceding claim, wherein each output of the pair of outputs is switchably coupled to the second supply voltage node during the second phase.

6. The differential amplifier of any of claims 1 to 3 further comprising: a pair of input capacitors (C31, C32), each input capacitor having a first input capacitor terminal coupled to an input-transistor-control-terminal of a respective input transistor a second input capacitor terminal configured to be switchably coupled to a second supply voltage node (302, 402) during a second phase ($\phi2$) and to be switchably coupled to a respective one of the pair of inputs (306, 308; 406, 408) during a third phase ($\phi3$).

7. The differential amplifier of claim 6, wherein each output of the pair of outputs is switchably coupled to the input-transistor-control-terminal of a respective input transistor during the second phase.

8. The differential amplifier of any preceding claim, further comprising a pair of latch transistors (M15, M16), each latch transistor comprising;

   A latch-transistor-control-terminal coupled to the load-transistor-control-terminal of a respective one of the pair of load transistors (M13, M14);
   a latch-transistor-first-terminal coupled to the load-transistor-first-terminal of a respective other of the pair of load transistors; and
   a latch-transistor-second-terminal coupled to the second supply voltage node (Vss).

9. The differential amplifier of any preceding claim further comprising a current source (312, 412) arranged between the first supply voltage node and the input-transistor-first-terminal of each input transistor.

10. The differential amplifier of any preceding claim, wherein the pair of input transistors are PMOS transistors and the pair of load transistors are NMOS transistors.

11. The differential amplifier of claim 10, wherein the first voltage supply node is configured to provide a supply voltage and the second voltage supply node is configured as a ground.

12. The differential amplifier of any of claims 1 to 9 wherein the pair of input transistors are NMOS transistors and the pair of load transistors are PMOS transistors.

13. The differential amplifier of claim 12, wherein the first voltage supply node is configured as a ground and the second voltage supply node is configured to provide a supply voltage.

14. The differential amplifier of any preceding claim wherein the first phase is a pre-charge phase, the second phase is an auto-zero phase and the third phase is a compare phase.

15. A method of operating a differential amplifier comprising a pair of inputs, a pair of outputs, a pair of input transistors and a pair of load transistors wherein each input transistor comprises an input-transistor-first-terminal coupled to a first supply voltage node, an input-transistor-second-terminal coupled to a respective one of the pair of outputs and an input-transistor-control-terminal, and each load transistor comprises a load-transistor-first-terminal coupled to a respective one of the pair of outputs, a load-transistor-second-terminal coupled to a second supply voltage node; and a load-transistor-control-terminal, the method comprising:

   precharging at least one capacitor to a bias voltage during a first phase;
   coupling the at least one capacitor between the load-transistor-first-terminal and the load-transistor-control-terminal of the pair of load transistors during a second phase and a third phase;
   coupling each input-transistor-control-terminal to the second supply voltage node during the second phase; and
   coupling each input-transistor-control-terminal to a respective one of the pair of inputs during the third phase.

FIG. 1

FIG. 2

200

FIG. 3

FIG. 4
300

FIG. 5

FIG. 6

400

Pre-charge $\phi_1$

Auto-zero $\phi_2$

Comp phase $\phi_3$

$(\phi2 \| \phi3) \phi_4$

<u>500</u>

FIG. 7

552 Vdd

554 $I_{bias}$

556

R41

$V_{bias}$

558

M41

560

<u>550</u>

FIG. 8

FIG. 9

EP 4 568 107 A1

Europäisches
Patentamt

European
Patent Office

Office européen
des brevets

# EUROPEAN SEARCH REPORT

**Application Number**

EP 24 16 2027

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 565 813 A (CONNELL LAWRENCE E [US] ET AL) 15 October 1996 (1996-10-15) | 1,3-15 | INV.<br>H03F3/00<br>H03F3/45 |
| A | * column 2, line 26 - column 6, line 31; figures 2-6 * | 2 | |
| A | RAJENDRAN SELVAKUMAR ET AL: "A Research Perspective on CMOS Current Mirror Circuits: Configurations and Techniques", RECENT ADVANCES IN ELECTRICAL & ELECTRONIC ENGINEERING (FORMERLY RECENT PATENTS ON ELECTRICAL & ELECTRONIC ENGINEERING), [Online] vol. 14, no. 4, 17 June 2021 (2021-06-17), pages 377-397, XP093184309, ISSN: 2352-0965, DOI: 10.2174/2352096514666210127140831 Retrieved from the Internet: URL:https://www.eurekaselect.com/190813/article> [retrieved on 2021-06-17] * section 2 entitled "Current mirror configurations" and section 3 entitled "Techniques for current mirror performance"; page 378 - page 395; figures 1-12 * | 1-15 | |

-/--

**TECHNICAL FIELDS SEARCHED (IPC)**

H03F

---

The present search report has been drawn up for all claims

| Place of search | Date of completion of the search | Examiner |
|---|---|---|
| The Hague | 27 August 2024 | Wienema, David |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

**EUROPEAN SEARCH REPORT**

Application Number

EP 24 16 2027

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | ENZ C C ET AL: "CIRCUIT TECHNIQUES FOR REDUCING THE EFFECTS OF OP-AMP IMPERFECTIONS: AUTOZEROING, CORRELATED DOUBLE SAMPLING, AND CHOPPER STABILIZATION", PROCEEDINGS OF THE IEEE, IEEE. NEW YORK, US, vol. 84, no. 11, 1 November 1996 (1996-11-01), pages 1584-1614, XP000642431, ISSN: 0018-9219, DOI: 10.1109/5.542410 * section IV.B entitled "The Open-Loop Offset Cancellation Principle"; page 1596; figure 20 * | 4,5 | |
| A | US 5 187 448 A (BROOKS TODD L [US] ET AL) 16 February 1993 (1993-02-16) * column 3, line 62 - column 5, line 26; figure 2 * | 8 | |

TECHNICAL FIELDS
SEARCHED        (IPC)

The present search report has been drawn up for all claims

| Place of search | Date of completion of the search | Examiner |
|---|---|---|
| The Hague | 27 August 2024 | Wienema, David |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
...........................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 16 2027

This annex lists the patent family members relating to the patent documents cited in the above-mentioned European search report.
The members are as contained in the European Patent Office EDP file on
The European Patent Office is in no way liable for these particulars which are merely given for the purpose of information.

27-08-2024

| Patent document cited in search report | | Publication date | Patent family member(s) | | Publication date |
|---|---|---|---|---|---|
| US 5565813 | A | 15-10-1996 | EP | 0743747 A2 | 20-11-1996 |
| | | | JP | 3181507 B2 | 03-07-2001 |
| | | | JP | H08316746 A | 29-11-1996 |
| | | | US | 5565813 A | 15-10-1996 |
| US 5187448 | A | 16-02-1993 | DE | 69325293 T2 | 24-02-2000 |
| | | | EP | 0554743 A1 | 11-08-1993 |
| | | | JP | 3158759 B2 | 23-04-2001 |
| | | | JP | H0629761 A | 04-02-1994 |
| | | | US | 5187448 A | 16-02-1993 |

EPO FORM P0459

For more details about this annex : see Official Journal of the European Patent Office, No. 12/82